# EUROPEAN PATENT APPLICATION

(11) **EP 0 955 709 A2**
(43) Date of publication of application: **10.11.1999**
(21) Application number: 99303312.5
(22) Date of filing: 28.04.1999
(51) Int. Cl.: H01S 3/19

(54) **Blue edge emitting laser**

(30) Priority: 06.05.1998 US 73721
(71) Applicant: XEROX CORPORATION, Rochester, New York 14644 (US)
(72) Inventor: Floyd, Philip D., Sunnyvale, CA 94086 (US); Hofstetter, Daniel, Sunnyvale, CA 94086 (US)
(74) Representative: Rackham, Stephen Neil

(57) **Abstract**

An independently addressable, edge emitting semiconductor laser (200) emitting light in the blue wavelength range of 390 to 430 nanometers comprises a gallium nitride-based laser structure grown by selective area epitaxy and lateral mask overgrowth. By appropriate patterning of a dielectric mask (206) on the gallium nitride layer (204) on a sapphire substrate (202), areas in a second gallium nitride layer (210) can have a low defect density upon which the remainder of the laser structure (218-230) can be formed.

## Description

This invention relates to a monolithic semiconductor laser structure and, more particularly, to an independently addressable, edge emitting laser in the blue wavelength range.

Monolithic solid state semiconductor lasers are very desirable light sources for high speed laser printing, optical fiber communications and other applications. Edge emitting lasers are currently used in the vast majority of applications. A common laser structure is a so-called "edge emitting laser" where light is emitted from the edge of a monolithic structure of semiconductor layers. Edge emitting lasers typically produce a beam with a large power output than surface emitting lasers.

Prior art quantum well edge emitting lasers can emit light in the wavelength range of about 600 to 650 nanometers (the red range) or in the range above 650 nanometers (the infrared range) . However, there are important applications for laser devices that emit light in the wavelength range around 400 nanometers (the blue range).

One ongoing problem with blue lasers in general is that gallium nitride and its alloys with indium and aluminum are used as the semiconductor layers in the blue laser structure. GaN itself cannot be used as a practical substrate. The problem is the lack of a suitable, lattice-matched substrate for the GaN semiconductor layers. Without a substrate with a lattice constant close to that of GaN, there will be a high density of extended defects in the nitride layers. An active layer of GaN and its alloys on a poorly lattice matched substrate will emit coherent blue light poorly and inefficiently, if at all.

The most commonly used and most readily available substrate is sapphire (Al₂O₃). Sapphire, however, has a similar crystal structure to GaN. An approximate epitaxial relationship between a sapphire substrate and a GaN alloy semiconductor laser structure can be obtained by matching specific crystallographic directions. However, a lattice mismatch of approximately 15 percent results from such a semiconductor structure.

It is an object of the present invention to provide an independently addressable, monolithic edge emitting laser structure for emitting light in the 390 to 430 nanometer range (the blue range).

The present invention provides an independently addressable, edge emitting laser in the blue wavelength range of 390 to 430 nanometers. The gallium nitride-based laser structure is grown by selective area epitaxy and lateral mask overgrowth. By appropriate patterning of a dielectric mask on the gallium nitride layer on a sapphire substrate, areas in a second gallium nitride layer can have a low defect density upon which the remainder of the laser structure can be formed.

Particular embodiments in accordance with this invention will now be described with reference to the accompanying drawings; in which:-
Figure 1 is a cross-sectional side view of the semiconductor layers of the substrate and buffer layer of the semiconductor structure of the present invention;
Figure 2 is a cross-sectional side view of the semiconductor layers of the blue edge emitting laser semiconductor structure of the present invention after deposition;
Figure 3 is a cross-sectional side view of the semiconductor layers of the blue edge emitting laser semiconductor structure of the present invention after etching;
Figure 4 is a cross-sectional side view of the semiconductor layers of the blue edge emitting laser semiconductor structure of the present invention; and,
Figure 5 is a cross-sectional side view of the semiconductor layers of the blue edge emitting laser semiconductor structure of Figure 4 with an alternate contact position.

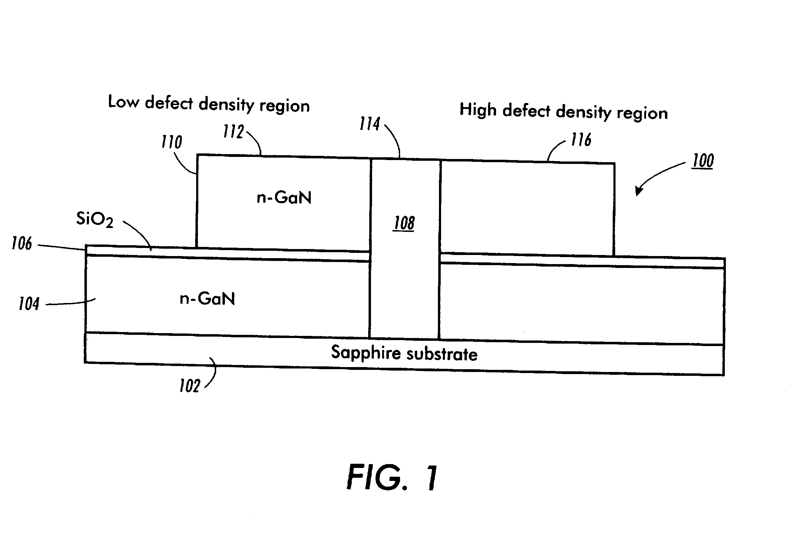

Figure 1 illustrates a gallium nitride (GaN) crystal structure 100 for use in a vertical cavity surface emitting laser in accordance with the present invention.

The structure 100 comprises a sapphire (Al₂O₃) substrate 102 upon which is first grown a n-gallium nitride (n-GaN) base layer 104 using an epitaxial deposition process known as metal-organic chemical vapor deposition ("MOCVD") as is well known in the art.

A 200 nm thick dielectric film 106 of silicon dioxide (SiO₂) is then deposited on the GaN base layer 104 by plasma-enhanced chemical vapor deposition ("PECVD") or by electron beam evaporation. The dielectric film 106 is then patterned by using standard photolithographic procedures and etching with hydrofluoric acid (HF).

A thin linear stripe 108 is etched down in the dielectric film 106 to expose the surface of the GaN base layer 104. A second n-gallium nitride (n-GaN) layer 110 of 4 µm thickness with a lateral width of 16 µm is then grown laterally starting at the thin exposed stripe 108. The GaN layer 110 grows laterally above the dielectric film 106 under high temperature and high ammonia flow, as described in Kapolnek et al., "Anistropic epitaxial lateral growth in GaN selective area epitaxy", Applied Physics Letters, vol. 71(9), 1 September 1997, pp. 1204-1206. Growth starts selectively only in the exposed GaN area 108, but not on the top surface of the SiO₂ layer 106. As the layer 110 gets thicker, the layer starts to laterally overgrow the SiO₂ layer 106. Since this laterally overgrown material is attached to the lower GaN layer 104 only on one side, it will grow without strain and, therefore, without dislocations. The second GaN layer 110 will be laterally overgrown over the GaN base layer 104 and above the dielectric film 106 on each side of the stripe 108.

The GaN layer 110 consists of three sections: a first or end section 112 atop one portion of the dielectric film 106, a second or middle section 114 atop the exposed stripe 108 of the GaN base layer 104 and a third or end section 116 atop another portion of the dielectric film 106. The two end portions 112 and 116 since they are deposited on top of the dielectric film 106 are in the low defect density regions of the GaN layer 110. The middle section 114 since it is deposited on the other first GaN base layer 104 is in the high defect density regions of the second GaN layer 110.

The laser heterostructures will be grown by epitaxy upon one section of the lateral overgrowth of the GaN layer 110 upon the dielectric film 106 and the linear stripe 108 of the GaN base layer 104. The subsequent growth of GaN based laser heterostructures over a patterned substrate 110 leads to low defect crystal areas 112 and 116 away from the high defect crystal area 114.

The dielectric film 106 deposited on the GaN base layer 104 can, in the alternative, be silicon nitride (SiNₓ) or silicon oxide nitride (SiON).

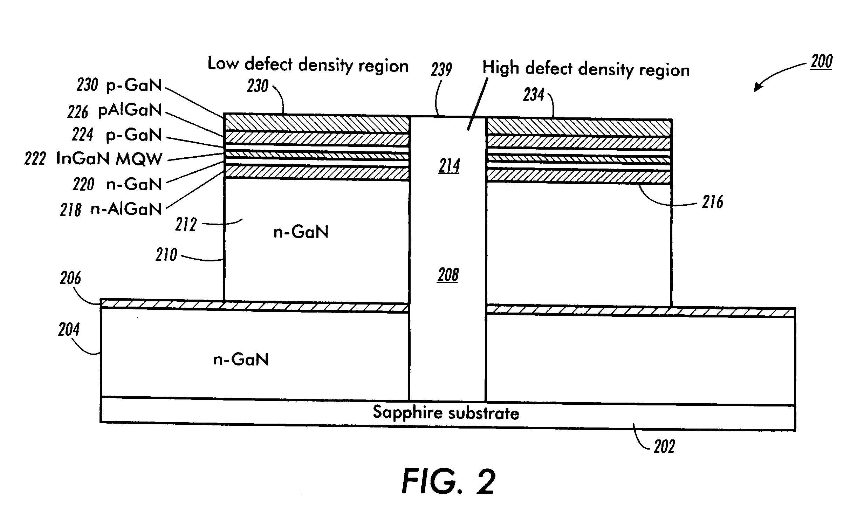

The blue edge emitting laser semiconductor structure 200 of Figure 2 is fabricated in accordance to the present invention.

The blue edge emitting laser structure 200 comprises a sapphire (Al₂O₃) substrate 202 upon which is first grown a n-gallium nitride (n-GaN) base layer 204 using an epitaxial deposition process known as metal-organic chemical vapor deposition ("MOCVD") as is well known in the art.

A 200 nm thick dielectric film 206 of silicon dioxide (SiO₂) is then deposited on the GaN base layer 204 by plasma-enhanced chemical vapor deposition ("PECVD") or by electron beam evaporation. The dielectric film 206 is then patterned by using standard photolithographic procedures and etching with hydrofluoric acid (HF).

A thin linear stripe 208 is etched down in the dielectric film 206 to expose the surface of the GaN base layer 204. A second n-gallium nitride (n-GaN) layer 210 of 4 µm thickness with a lateral width of 16 µm is then selectively deposited on the dielectric film 206 and the thin exposed stripe 208 of the GaN base layer 204. The second GaN layer 210 will be laterally overgrown over the GaN base layer 204 and above the dielectric film 206 on each side of the stripe 208.

The GaN layer 210 consists of three sections: a first or end section 212 atop one portion of the dielectric film 206, a second or middle section 214 atop the exposed stripe 208 of the GaN base layer 204 and a third or end section 216 atop another portion of the dielectric film 206. The two end portions 212 and 216 since they are deposited on top of the dielectric film 206 are in the low defect density regions of the GaN layer 210. The middle section 214 since it is deposited on the GaN base layer 204 is in the high defect density regions of the second GaN layer 210.

The laser heterostructure is then deposited on the GaN layer 210.

Using Organometallic Vapor Phase Epitaxy ("OMPVE"), a lower n-Al_{0.08}Ga_{0.92}N aluminum gallium nitride cladding layer 218 is deposited on the GaN layer 210. The n-Al_{0.08}Ga_{0.92}N aluminum gallium nitride cladding layer 218 has a thickness of 0.5 µm and is silicon doped to a concentration of 5 x 10¹⁷ cm⁻³. A first lower n-GaN confinement layer 220 is deposited upon the lower cladding layer 218. The n-GaN confinement layer 220 has a thickness of 100 nm and is silicon doped to a concentration of 10¹⁸ cm⁻³. An In_{0.15}Ga_{0.85}N/GaN multiple quantum well active layer 222 is deposited on the confinement layer 220. The In_{0.15}Ga_{0.85}N/GaN multiple quantum well active layer 222 is undoped and has a thickness of 120 nm. A second upper p-GaN confinement layer 224 is deposited upon the multiple quantum well active layer 222. The p-GaN confinement layer 224 has a thickness of 100 nm and is magnesium doped to a concentration of 10¹⁸ cm⁻³. An upper p-Al_{0.08}Ga_{0.92}N aluminum gallium nitride cladding layer 226 is deposited on the confinement layer 224. The p-Al_{0.08}Ga_{0.92}N aluminum gallium nitride cladding layer 226 has a thickness of 0.5 µm and is magnesium doped to a concentration of 5 x 10¹⁷ cm⁻³. A third p-GaN contact layer 228 is deposited on the upper cladding layer 226. The contact layer 228 has a thickness of 120 nanometers and is magnesium doped to a concentration of 5 x 10¹⁷ cm⁻³.

The multiple quantum well layer 222 forms the active region for emission of light in the blue wavelengths of 390 to 430 nanometers.

The laser heterostructure 200 is formed of gallium nitride semiconductor layers and its alloys with aluminum and/or indium.

The three sections of the second GaN layer 210 extend up through the rest of subsequently deposited semiconductor layers of the laser structure 200. Thus the laser structure 200 has semiconductor layers deposited in the first or end section 230 from the first section 212 of the GaN layer 210 atop one portion of the dielectric film 206 and the third or end section 234 from the third section 216 of the GaN layer 210 atop another portion of the dielectric film 206. The two end portions 230 and 234 since they are deposited on top of the low defect density regions of GaN layer 210 are in the low defect density regions of the laser structure 200. The middle section 232 from the middle section 214 of the GaN layer 210 since it is deposited on the GaN base layer 204 is in the high defect density regions of the laser structure 200.

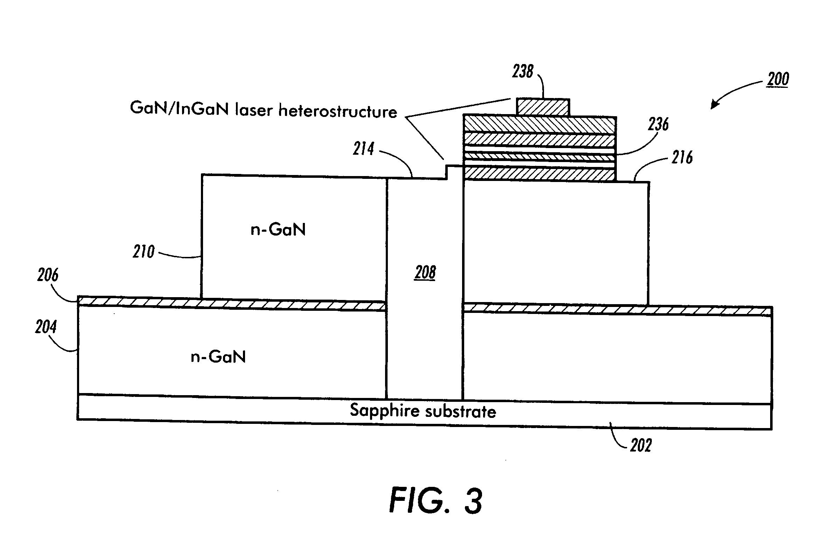

As illustrated in Figure 3, a dielectric masking layer (not shown) such as a photoresist, is pattern masked on the surface of the layer 228 and the unmasked portion of the laser structure 200 is etched away down the second N-GaN layer 210 to form a ridge waveguide 236. The pattern masking and dry etching or reactive ion etching are techniques common to semiconductor structure manufacture and known in the art.

The ridge waveguide 236 portion of the laser structure 200 extends above the third or end section 216 of the GaN layer 210 after etching.

The ridge waveguide 236 forms the lateral optical confinement structure for the semiconductor laser 200 and thus the ridge precisely defines the origin of the edge emission of light from the semiconductor laser. The ridge waveguide is typically a small ridge of semiconductor material with a generally flat upper surface and sloped sidewalls on top of the active semiconductor layer in a semiconductor laser structure.

One method of forming the ridge waveguide is to etch away a portion of the upper cladding layer 226 (and contact layer 230) of the epitaxially deposited semiconductor layers of the laser structure, leaving a narrow ridge 238 of the cladding layer material to define the lateral ridge waveguide. The particular geometry of the ridge depends upon the etching means.

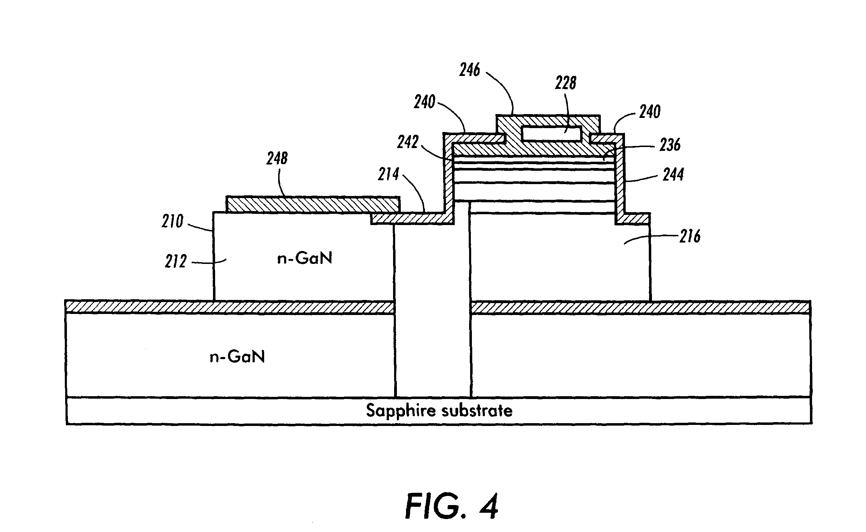

As seen in Figure 4, an insulating layer 240 of dielectric materials, such as SiNₓ, SiO₂ or SiONₓ, is deposited on the sidewalls 242 and 244 of the ridge waveguide 236 of the laser structure. The insulating layer will also cover a portion of the surface of the contact layer 228.

A p-contact 246 of Cr-Au or Ti-Pt-Au is formed by metal evaporation on the uninsulated surface of the spacer layer 230. Alternately, an InGaN contact layer (not shown) can be deposited on the contact layer 228 first, followed by the formation of the p-contact 246.

A n-contact 248 of Cr-Au or Ti-Pt-Au is formed by metal evaporation on the first or end section 212 of the GaN layer 210.

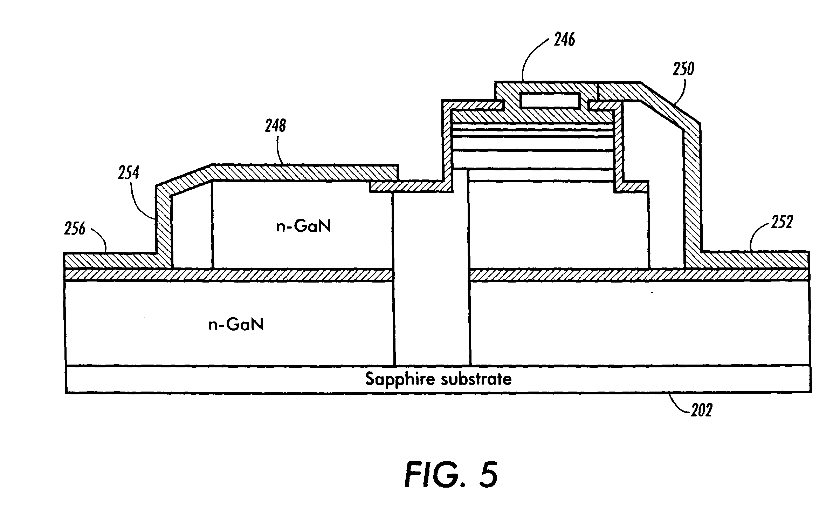

As shown in Figure 5, an air-bridge 250 of Cr-Au or Ti-Pt-Au connects the p-contact 246 to a much larger contact pad 252 on the surface of the sapphire substrate 202. Similarly, an air-bridge 254 of Cr-Au or Ti-Pt-Au connects the n-contact 248 to a much larger contact pad 256 on the surface of the sapphire substrate 202.

Current will flow through conventional electrodes from the p-contact 246 through the contact layer 228, through the upper cladding layer 226, through the confinement layer 224, through the multiple quantum well active layer 222 to forward bias the layer to emit light in the blue wavelengths, through the confinement layer 220, through the cladding layer 218, through the third section 216 of the GaN layer 210, through the second section 214 of the GaN layer 210, and through the first section 212 of the GaN Layer 210 to the n-contact 248.

The active region will emit light through the edge of the laser structure 200. Not shown in the Figure are the conventional reflecting facets forming the optical cavity with and perpendicular to the quantum well active layer 222 at opposite ends of the laser structure 200.

Alternately, to bridge the metal contacts down without an air bridge, an insulating dielectric and conformational metallization can be used to connect large contacts on the substrate to the smaller contacts on the laser structure. Similarly, proton implantation or conformal metal evaporation may be used for the contacts.

## Claims

1. An edge emitting laser (200) for emitting coherent light in wavelength range of 390 to 430 nanometers comprising:
a sapphire substrate (202);
a first gallium nitride semiconductor layer (204) formed on said sapphire substrate (202);
a dielectric material layer (206) formed on said first gallium nitride semiconductor layer (204), said dielectric material layer (206) having a stripe (208) exposing a portion of the surface of said first gallium nitride semiconductor layer (204),
a second gallium nitride semiconductor layer (210) formed on said dielectric material (206) layer and said stripe (208) ;
a plurality of semiconductor layers (218-230) formed on a section of said second gallium nitride semiconductor layer (210) formed on said dielectric material layer (206);
one or more of said plurality of semiconductor layers (222) forming an active region; and,
first and second electrodes (246,248) which enable biasing of said active region (222) to emit coherent light in wavelength range of 390 to 430 nanometers.

2. An edge emitting laser according to Claim 1, wherein said plurality of semiconductor layers (218-230) are gallium nitride or its alloys with indium and aluminum.

3. An edge emitting laser according to Claim 1 or 2, wherein said plurality of semiconductor layers form a ridge waveguide (236) .

4. An edge emitting laser according to any one of the preceding claims, wherein said first electrode (246) is formed on a portion of said plurality of semiconductor layers (218-230).

5. An edge emitting laser according to any one of the preceding claims, wherein said second electrode (248) is formed on said second gallium nitride semiconductor layer (210).
